# EUROPÄISCHE PATENTANMELDUNG

(11) **EP 0 681 321 A1**
(43) Veröffentlichungstag der Anmeldung: **08.11.1995**
(21) Anmeldenummer: 95201054.4
(22) Anmeldetag: 24.04.1995
(51) Int. Cl.: H01L 21/336, H01L 21/8238

(54) **Herstellungsverfahren für MOSFETs mit LDD**

(30) Priorität: 03.05.1994 DE 4415568
(71) Anmelder: SIEMENS AKTIENGESELLSCHAFT, D-80333 München (DE)
(72) Erfinder: Kerber, Martin, Dr., D-81827 München (DE)

(57) **Zusammenfassung**

Herstellungsverfahren für MOSFETs, bei dem auf die mit einer Gate-Elektrode versehene Oberfläche eines Wafers ganzflächig eine TEOS-Schicht abgeschieden wird, durch diese Schicht eine Implantierung für Anschlußbereiche (5) von Source und Drain vorgenommen wird, wobei die seitlich der Gate-Elektrode befindlichen Anteile der TEOS-Schicht als Spacer fungieren, die TEOS-Schicht entfernt wird und eine zweite Implantierung zur Herstellung von Seitenbereichen (7) der Anschlußbereiche (5) für LDD (lightly doped drain) vorgenommen wird.

## Beschreibung

Die vorliegende Erfindung betrifft ein Herstellungsverfahren für Feldeffekttransistoren mit LDD-Implantationen für niedrige Feldstärken an den Gatekanten.

Bei MOSFETs mit kurzen Kanallängen treten im Betrieb an den Kanten des Gate hohe Feldstärken auf, die die Ladungsträger derart aufheizen, daß es zu unerwünschter Degradation der elektrischen Eigenschaften kommt (hot carrier degradation). Gegenüber den konventionellen lateralen Verteilungen des Dotierstoffes, die sich im wesentlichen aus der Diffusion ergeben, erhält man mit kastenförmigen Implantationsprofilen ein besseres Verhältnis von Betriebsspannung zu maximaler Feldstärke. Zu diesem Zweck werden üblicherweise an den Kanten des Gate zwei Implantationen eingebracht, die einen flacheren Anstieg der Konzentration des Dotierstoffes zwischen dem Kanalbereich und den Anschlußbereichen sicherstellen. Um die beiden Gebiete dieser Implantationen voneinander und von dem Bereich des Gate abzusetzen, werden Distanzelemente (sidewall spacer) verwendet. Die bei den Implantationen eingesetzten Lackmasken, mit denen die nicht implantierten Bereiche abgedeckt werden, müssen vor jedem Implantationsschritt neu aufgebracht werden, weil zwischen den Implantationen Prozeßschritte bei hoher Temperatur erfolgen, die die Lackmaske zerstören wurden. Temperaturbehandlungen führen im Zusammenhang mit anomaler Diffusion aufgrund von Punktdefekten zu Diffusion und abfallenden Dotierstoffprofilen. Bei herkömmlichen Prozeßführungen ist mindestens eine anisotrope Ätzung erforderlich, um die genannten Spacer herzustellen, was zu einem unerwünschten Atzangriff auf die oberste Halbleiterschicht führen kann.

Aufgabe der vorliegenden Erfindung ist es, ein verbessertes Herstellungsverfahren für Feldeffekttransistoren anzugeben, bei dem insbesondere ein LDD (lightly doped drain) auf einfache Weise realisierbar ist.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren wird zunächst in herkömmlicher Weise die Gate-Elektrode auf einer Dielektrikumschicht, z. B. einer Oxidschicht, auf der Oberseite eines Wafers hergestellt. Bei einem Silizium-Wafer ist die Gate-Elektrode z. B. Polysilizium. Nach einer Oxidation der Oberfläche dieser Gate-Elektrode, die notwendig ist, um die Durchbruchfestigkeit an der Gatekante zu verbessern, wird ganzflächig eine für die Implantierung vorgesehene Hilfsschicht, im folgenden als Implantierungsschicht bezeichnet, aufgebracht. Die Dicke dieser Implantierungsschicht wird so bemessen, daß bei der nachfolgenden Implantierung von Dotierstoff der an den Flanken der Gate-Elektrode befindliche Anteil dieser Implantierungsschicht als Spacer wirkt. Die Implantierung erfolgt dann nur in denjenigen Bereichen der Oberfläche, in denen diese Implantierungsschicht im wesentlichen nur in horizontaler Richtung aufgebracht ist. Eine für breite Spacer dick aufgebrachte Implantierungsschicht kann ggf. in diesen horizontalen, für die Implantierung vorgesehenen Bereichen durch eine anisotrope Ätzung in vertikaler Richtung gedünnt werden, wobei die Breite der Spacer höchstens unwesentlich vermindert wird. Die nicht für Implantierung vorgesehenen Bereiche außerhalb eines Gebietes um das Gate können durch eine Lackmaske abgedeckt werden. Diese Lackmaske kann bei den folgenden Verfahrensschritten stehenbleiben, so daß bei dem erfindungsgemäßen Verfahren insgesamt nur eine derartige Lackmaske erforderlich ist, die sowohl bei der Implantierung der hoch dotierten Anschlußbereiche von Source und Drain als auch bei einer möglichen weiteren Implantierung zur Herstellung von LDD-Bereichen verwendet wird. Nach der Implantierung kann die Implantierungsschicht isotrop gedünnt oder entfernt werden, so daß näher an der Gate-Elektrode befindliche und zuvor abgeschirmte Bereiche einer weiteren Implantierung zugänglich sind. Bei gänzlicher Entfernung der Implantierungsschicht können auch unmittelbar an die Gate-Elektrode angrenzende Bereiche implantiert werden. Es wird erneut Dotierstoff eingebracht, wobei die bei der ersten Implantierung hergestellten dotierten Bereiche ihre endgültige Dotierungskonzentration erhalten. Die zweite Implantierung wird z. B. so vorgenommen, daß die zuvor abgeschirmten Bereiche die für die Ausbildung eines LDD erforderliche Dotierstoffkonzentration erhalten. Anschließend werden in einem Hochtemperaturschritt alle Implantierungen gleichzeitig ausgeheilt und der eingebrachte Dotierstoff aktiviert. Bei diesem Verfahrensschritt verteilt sich der eingebrachte Dotierstoff in dem Polysilizium, das vorzugsweise für die Gate-Elektrode verwendet wird, vergleichsweise rasch, der in den einkristallinen Wafer eingebrachte Dotierstoff diffundiert dagegen nur unwesentlich, so daß der Dotierstoff angrenzend an das Gate ein stufenförmiges Profil behält, während die Gate-Elektrode praktisch vollständig dotiert ist.

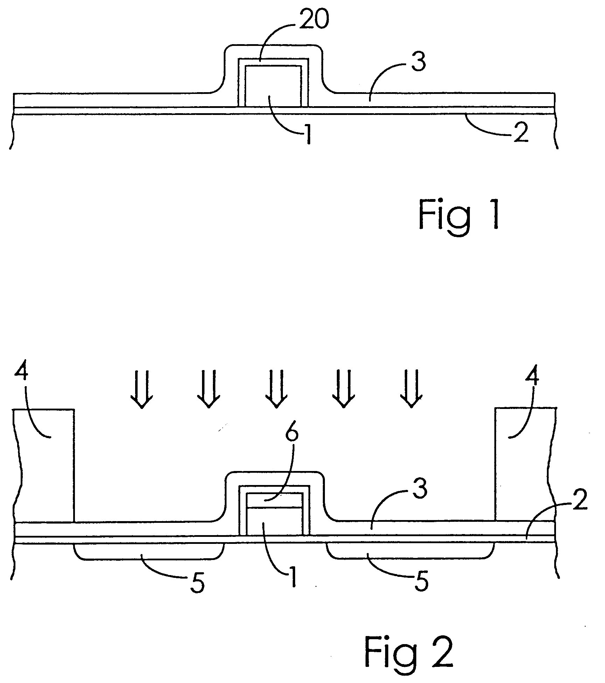

Es folgt die Beschreibung einer Ausgestaltung des erfindungsgemäßen Verfahrens anhand der Figuren 1 bis 4, die Zwischenstufen des mit dem erfindungsgemäßen Verfahren hergestellten Transistors im Querschnitt nach verschiedenen Verfahrensschritten zeigen.

Fig. 1 zeigt die Gate-Elektrode 1 auf einer Dielektrikumschicht 2, z. B. einer durch Oxidation erzeugten Oxidschicht auf der Oberseite des Wafers. Eine weitere Dielektrikumschicht 20 überzieht die Oberseite der Gate-Elektrode 1. Diese weitere Dielektrikumschicht 20 kann z. B. nach der Strukturierung der Gate-Elektrode durch thermische Oxidation hergestellt werden. Bei einer derartigen Reoxidation des Wafers erhält man ein sehr dichtes Oxid (z. B. SiO₂ bei einem Silizium-Wafer mit einer Gate-Elektrode aus Polysilizium), was bei der nachfolgenden Entfernung der Implantierungsschicht die Gate-Elektrode wegen einer geringeren Ätzrate dieses die Gate-Elektrode umgebenden Oxids schützt. Fig. 1 zeigt die ganzflächig aufgebrachte Implantierungsschicht 3, die hier z. B. ein abgeschiedenes Oxid, wie z. B. TEOS (Tetraethylorthosilan), ist. Diese Implantierungsschicht 3 dient in dem nachfolgenden Schritt zur Abschirmung der an die Gate-Elektrode 1 seitlich angrenzenden Bereiche.

Um die Bereiche der Implantierung seitlich zu begrenzen, was insbesondere dann erforderlich ist, wenn auf demselben Wafer NMOS- und PMOS-Transistoren hergestellt werden sollen, wird wie in Fig. 2 dargestellt eine Lackmaske 4 aufgebracht, die die für die Implantierung vorgesehenen Bereiche frei läßt. Die Implantierung wird dann vorgenommen, wie in Fig. 2 durch die Pfeile dargestellt ist. Die lateralen Implantate bilden die für den Anschluß von Drain und Source vorgesehenen Anschlußbereiche 5 unter der Oxidschicht 2. Bei dieser Implantierung wird ebenfalls ein oberer Schichtanteil 6 der Gate-Elektrode 1 dotiert. Falls die Implantierungsschicht für die vorgesehene Spacer-Breite sehr dick aufgebracht ist, kann vor der Implantierung in Richtung der in Figur 2 eingezeichneten Pfeile ein anisotroper Ätzschritt erfolgen, um die horizontalen Anteile der Implantierungsschicht zu dünnen. Durch die Wahl der Dicke der Implantierungsschicht 3 und der Energie der Implantierung wird erreicht, daß zwischen der Gate-Elektrode 1 und den Anschlußbereichen 5 ein schmaler Streifen vorgesehener Breite übrigbleibt, in den kein Dotierstoff eingedrungen ist.

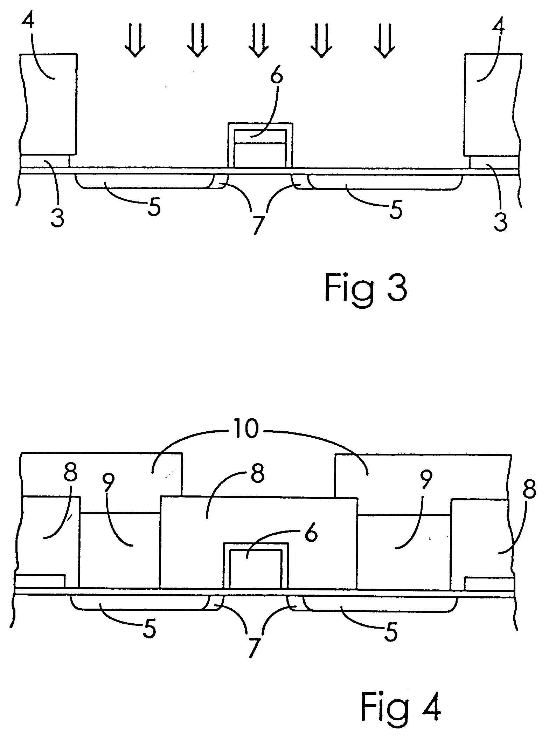

Dann kann die Implantierungsschicht in der Öffnung der Lackmaske 4 isotrop gedünnt oder vollständig entfernt werden, wie als Beispiel in Figur 3 gezeichnet ist. Die ggf. vorhandene Lackmaske 4 bleibt stehen. Die Implantierungsschicht 3 kann z. B. naßchemisch rückgeätzt werden, wobei bei Verwendung von TEOS auf Silizium bei einer Selektivität von 6:1 zum relativ dichten Oxid der an der Oberfläche liegenden Anteile der Dielektrikumschichten 2, 20, insbesondere an den unteren Kanten der Gate-Elektrode, eine ausreichende Sicherheit besteht, daß das die Gate-Elektrode 1 isolierende Oxid nicht angegriffen wird. Der bei dem Verfahrensschritt, der in Fig. 3 dargestellt ist, implantierte Dotierstoff wird in einer Konzentration eingebracht, die zur Ausbildung eines LDD in den an das Gate angrenzenden Seitenbereichen 7 der Anschlußbereiche 5 geeignet ist. Die beiden Verfahrensschritte der beiden Implantierungen können dann ggf. mit andersartigen Implantierungen, z. B. für entgegengesetzten Leitungstyp, wiederholt werden, falls z. B. komplementäre Transistoren auf demselben Wafer hergestellt werden sollen. Dazu wird die Lackmaske 4 entfernt und durch eine andere Lackmaske ersetzt, die die bereits implantierten Transistorgebiete abdeckt. Es wird dann entsprechend der für die komplementären Transistoren vorgesehene Dotierstoff eingebracht. Falls keine LDDs ausgebildet werden sollen, genügt auch eine einzelne Implantierung. Das erfindungsgemäße Verfahren läßt sich in einfacher Weise für beide Transistorarten durchführen. Die Implantierungsschicht 3 wird zu Beginn ganzflächig aufgebracht, so daß sie nach dem Durchführen des Implantierungsschrittes für den einen Leitungstyp auf den Bereichen der komplementären Transistoren noch vorhanden ist und dort für die erfindungsgemäße Durchführung der Implantierung für den entgegengesetzten Leitungstyp verwendet werden kann.

Bei Herstellung komplementärer Transistoren auf demselben Wafer können auf einfache Weise die Breiten der Seitenbereiche 7 für die Transistorarten unterschiedlich eingestellt werden. Die Dicke der Implantierungsschicht 3 wird dann so gewählt, daß sie der vorgesehenen maximalen Breite von Seitenbereichen entspricht. Es kann dann durch isotropes Rückätzen der Implantierungsschicht jeweils in einem für eine bestimmte Transistorart vorgesehenen Bereich die Breite des als Spacer fungierenden Anteils individuell für diese Transistorart eingestellt werden. Im Gegensatz zu herkömmlichen Verfahren genügt dann eine einzelne Abscheidung und, falls nur zwei verschiedene Transistorarten hergestellt werden sollen, eine einmalige isotrope Rückätzung dieser für die Funktion als Spacer vorgesehenen Implantierungsschicht 3.

Im Anschluß an die Implantierungen wird in einem Hochtemperaturschritt der Dotierstoff aktiviert, wobei sich der Dotierstoff im Polysilizium sehr rasch verteilt, weshalb der dotierte Schichtanteil 6 einer Gate-Elektrode aus Polysilizium im Anschluß an diesen Verfahrensschritt wie in Figur 4 dargestellt auf die gesamte Gate-Elektrode ausgedehnt sein kann. Das Profil des Dotierstoffes bleibt in den Seitenbereichen 7 im wesentlichen rechteckig. Die Implantierungsenergien bei den beiden Implantierungsschritten werden so gewählt, daß bei dem fertigen Transistor die Anschlußbereiche 5 ausreichend niederohmig sind. Die Fertigstellung des Transistors, die in der üblichen Weise erfolgt, umfaßt dann das Aufbringen von Anschlußkontakten 9 (s. Fig. 4) in Öffnungen einer Passivierungsschicht 8 (z. B. BPSG, Borphosphorsilikatglas) und das Aufbringen von Metallisierungen 10. Wenn MOSFETs mit LDDs hergestellt werden, braucht man im Gegensatz zu bisher bekannten Verfahren, bei denen zunächst die niedriger dotierten Übergangsbereiche neben der Gate-Elektrode implantiert werden, dann TEOS-Spacer hergestellt werden und dann die hoch dotierten Source- und Drain-Bereiche implantiert werden, bei dem erfindungsgemäßen Verfahren nur eine Lackmaske, weil vor dem Aufbringen der TEOS-Schicht keine Implantierung erfolgt und noch keine Lackmaske erforderlich ist.

## Patentansprüche

1. Verfahren zur Herstellung von MOSFETs, bei dem in einem ersten Schritt auf einer Oberseite eines Wafer eine Dielektrikumschicht (2) und darauf eine Gate-Elektrode (1) hergestellt werden,
in einem zweiten Schritt ganzflächig eine Implantierungsschicht (3) in einer den nachfolgenden Schritt ermöglichenden Dicke aufgebracht wird,
in einem dritten Schritt unter Verwendung der die Flanken dieser Gate-Elektrode (1) bedeckenden Anteile dieser Implantierungsschicht (3) als Spacer zur Ausbildung von Anschlußgebieten (5) von Source und Drain bestimmte Implantierungen von Dotierstoff erfolgen und
in einem vierten Schritt eine Aktivierung der mit diesen Implantierungen eingebrachten Dotierstoffe erfolgt.

2. Verfahren nach Anspruch 1,
bei dem in dem dritten Schritt
in einem vorangehenden Schritt die Implantierungsschicht (3) anisotrop rückgeätzt wird, so daß die auf der Dielektrikumschicht (2) vorhandenen Anteile der Implantierungsschicht (3) gedünnt werden und die die Flanken der Gate-Elektrode bedeckenden Anteile der Implantierungsschicht (3) die ursprüngliche Schichtdicke im wesentlichen beibehalten.

3. Verfahren nach Anspruch 1 oder 2,
bei dem in dem dritten Schritt
in einem ersten weiteren Schritt die Implantierungsschicht (3) isotrop rückgeätzt wird und in einem zweiten weiteren Schritt eine weitere Implantierung von Dotierstoff vorgenommen wird.

4. Verfahren nach einem der Ansprüche 1 bis 3,
bei dem die Dielektrikumschicht (2) auf Silizium hergestellt wird und
bei dem die Gate-Elektrode (1) aus Polysilizium hergestellt wird.

5. Verfahren nach einem der Ansprüche 1 bis 4, bei dem zwischen dem zweiten und dem dritten Schritt eine Lackmaske (4), die Bereiche, die für bestimmte Implantierungen vorgesehen sind, frei laßt, aufgebracht wird und
zwischen dem dritten und dem vierten Schritt diese Lackmaske (4) entfernt wird, eine weitere Lackmaske, die Bereiche, die für andersartige Implantierungen vorgesehen sind, frei läßt, aufgebracht wird und der dritte Schritt mit dieser andersartigen Implantierung wiederholt wird.

6. Verfahren nach Anspruch 5,
bei dem in dem von einer der Lackmasken frei gelassenen Bereich vor der Implantierung die Implantierungsschicht (3) isotrop rückgeätzt wird.

7. Verfahren nach Anspruch 5 oder 6,
bei dem in den von den Lackmasken frei gelassenen Bereichen jeweils PMOS- bzw. NMOS-Transistoren hergestellt werden.
